# EUROPEAN PATENT SPECIFICATION

(11) **EP 2 095 023 B1**
(45) Date of publication and mention of the grant of the patent: **17.11.2010**
(21) Application number: 07857487.8
(22) Date of filing: 12.12.2007
(51) Int. Cl.: F24C 15/00, H01H 3/08, H05K 7/20

(54) **A HOUSEHOLD APPLIANCE**
HAUSHALTSGERÄT
APPAREIL DOMESTIQUE

(30) Priority: 18.12.2006 TR 200607204
(43) Date of publication of application: 02.09.2009
(73) Proprietor: Arçelik Anonim Sirketi, 34950 Istanbul (TR)
(72) Inventor: KALAYCI, Cemalettin, 34950 Istanbul (TR); KARATAS, Haluk, 34950 Istanbul (TR)
(74) Representative: Okat, Tolga
(86) International application number: PCT/EP2007/063824
(87) International publication number: WO 2008/074714

(56) References cited:
- EP-A- 1 248 274
- EP-A- 1 457 740
- WO-A-2006/067764
- US-A- 3 659 579

## Description

The present invention relates to a household appliance wherein the electronic elements such as the control card etc. on the panel are cooled.

Display screens are provided on the control panels of household appliances such as an oven, refrigerator, washing machine, dishwasher etc. These screens enable the user to see some of the information relating to the household appliance. Moreover, various functions of the appliance can be adjusted by the electronic control knobs on the panel. These control knobs and the display screens are connected to an electronic card and function by means of this electronic card.

The heating of the household appliance during use results in excessive heating of the said electronic cards. This generated heat sometimes leads to malfunctioning of the elements on the electronic cards. Therefore, the electronic cards in household appliances are protected from the effect of this heat during the operation of the appliance. The cards are either heat insulated to prevent excessive heating or are cooled by various methods.

Forced air circulation is commonly used for cooling the electronic cards. The air to cool the card is generally supplied from the outside by means of a fan and the card is cooled by making the air circulate from around the card.

Several air inlet holes are left on the appliance for aspiration of air from the outside to the interior of the household appliance for cooling the card. These air inlet holes can be arranged on any surface of the appliance. The air inlets are made in front of the appliance since in general the control cards are disposed behind the front panel to be in the proximity of the control knobs and the display screen.

In state of the art European Patent Document No EP0726425, a cooling chamber is described that is fitted above the cooking chamber containing a fan inside for cooling only the front region of the appliance and the electrical elements. The aspiration of air from the outside by means of the fan is received through the suction and/or blower openings formed in the front region of the side wall.

In another state of the art United States of America Patent Document No US6097000, a food-cooking appliance is explained having a fan to generate air flow for cooling the electronic components.

In state of the art, the air aspiration from the outer surrounding is maintained by the holes that are generally arranged on the front and side surfaces of the appliance. In this state, the air inlet holes are disposed on the front surface of the appliance that is most viewed by the user. This is an esthetically unwanted situation. Therefore, these air inlets are kept as small as possible and hidden from view so as not to be noticed.

The object of the present invention is to design a household appliance wherein the electronic control card on the panel is cooled more effectively.

The household appliance designed to fulfill the objective of the present invention; explicated in the first claim and the respective claims thereof, comprises a control card to which the display screen, control knobs etc. are connected, a fan that aspirates air from the outside environment and discharges the aspirated air by circulating around the card for cooling the said control card and a channel in which the control knobs are emplaced. The air aspirated from the outside environment by the fan enters through the gap on the periphery of the control knobs into the channel and leaves the channel to reach the card through the ventilation openings on the side wall of the channel and the card is cooled. Since the diameter of the channel is greater than the portion of the knob body fitted into the channel, a gap is provided allowing passage of air between the inner surface of the channel and the outer surface of the knob portion fitted into the channel. Since air aspiration from the outside is supplied around the control knobs on the front panel of the household appliance, there is no need for additional air inlets on the panel.

When air entrance over more than one knob is supplied, the air is enabled to affect the different places of the card at the same rate and thus the card can be cooled more homogeneously.

The household appliance designed to fulfill the objective of the present invention is illustrated in the attached figures, where:

Figure 1 - is the perspective view of a household appliance.

Figure 2 - is the perspective view of a panel when the control knobs are assembled.

Figure 3 - is the perspective view of a panel when the control knobs are not assembled.

Figure 4 - is the exploded view of a panel.

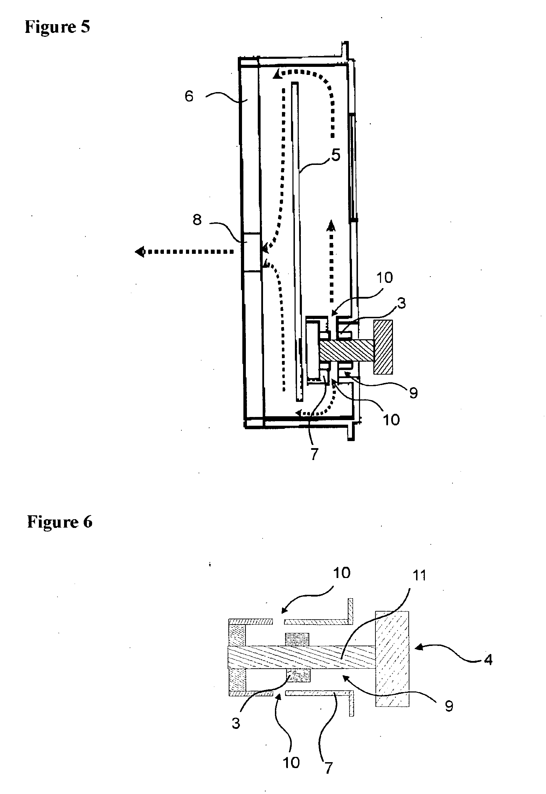

Figure 5 - is the schematic view of the panel.

Figure 6 - is the schematic view of a channel when the knob is assembled.

Figure 7 - is the rear perspective view of a panel.

Figure 8 - is the schematic view of the cross-section of a panel. ,

The elements illustrated in the figures are numbered as follows:
1. Household appliance
2. Panel
3. Holding means
4. Knob
5. Control card
6. Lid
7. Channel
8. Fan
9. Gap
10. Opening
11. Body

The household appliance (1) of the present invention comprises a panel (2), a control card (5) mounted behind the panel (2), at least one knob (4) connected to the control card (5), a fan (8) disposed behind the control card (5) that cools the control card (5) by supplying air flow, a channel (7) situated on the panel (2) wherein the knob (4) is placed, a gap (9) between the knob (4) and the channel (7) allowing air to pass, a holding means (3) inside the channel (7) that secures the knob (4) such that a gap (9) is left between the knob (4) and the channel (7) and at least one opening (10) situated on the wall of the channel (7) such that the air entering the channel (7) reaches the control card (5).

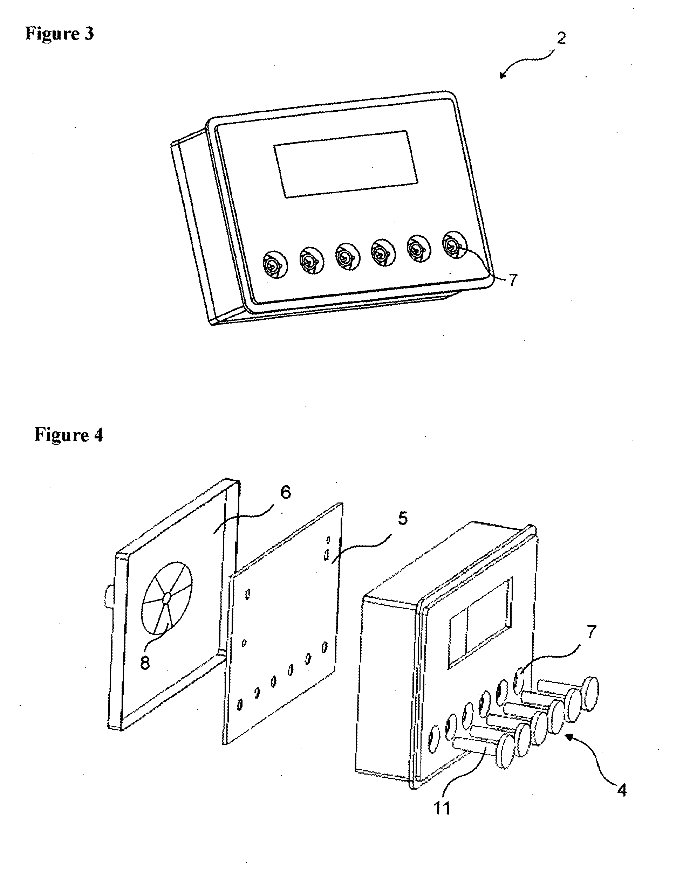

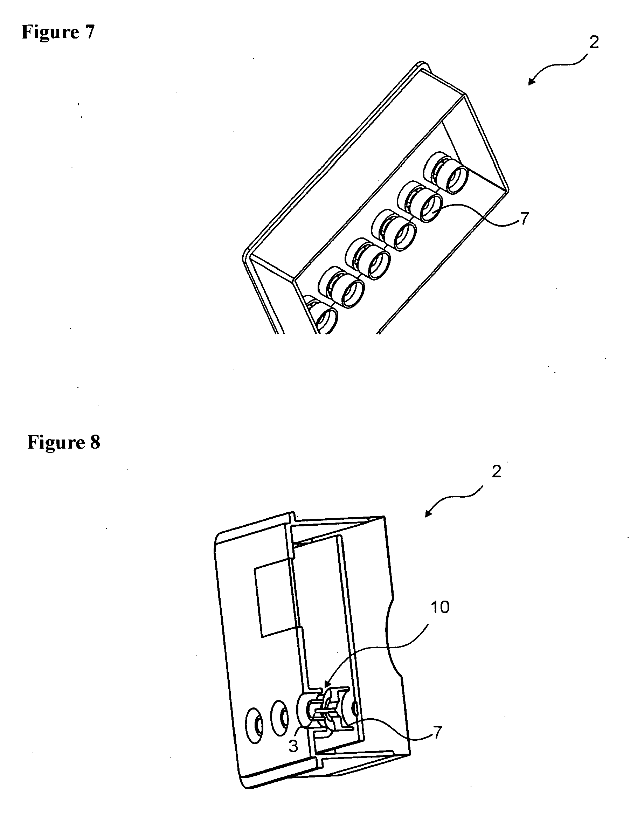

The knobs (4) and the displays are situated on the panel (2). The panel (2) is formed as a chamber with the surface facing inside the household appliance (1) being open and the other surfaces being closed (Figure 8). The control card (5) is disposed behind this panel (2) to which the knobs (4) and the display screen are connected. Channels (7) are arranged on the façade of the panel (2) viewed from the exterior of the household appliance (1). The knobs (4) mounted to the panel (2) can reach the control card (5) by means of these channels (7) (Figure 4).

The knob (4) comprises a body (11) that is seated into the channel (7).

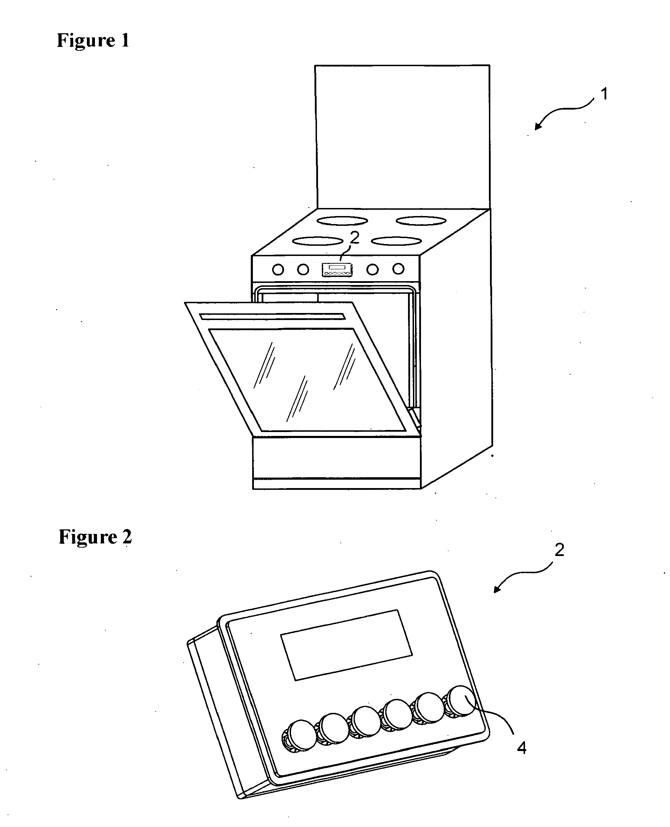

The channels (7) serve as housing for the knobs (4) and the knob (4) passing through the channel (7) is seated on the holding means (3) inside the channel (7). Commands are transmitted to the control card (5) by means of the knobs (4). The channel (7) is shaped like a cylinder with one end extending over the panel (2) and the other end extending to the control card (5). The holding means (3) is disposed on its end near the control card (5) whereto the body (11) will be secured. The knob (4) is mounted to the channel (7) from its end on the panel (2). A gap (9) is provided between the inner surface of the channel (7) and the outer surfaces of the knob (4) portion fitted into the channel (7) allowing passage of air since the diameter of the channel (7) is greater than the diameter of the body (11) and by means of the knob (4) being seated on the holding means (3) without getting in contact with the channel (7) (Figure 2).

As the knob (4) is seated on the holding means (3), the knob (4) is enabled to be disposed without getting in contact with the channel (7) and thus a gap (9) is formed between the knob (4) and the channel (7) that allows air to pass. By means of this gap (9) the need to further provide air inlet holes on the panel (2) or the household appliance (1) is deemed unnecessary. The air that enters from the gap (9) into the channel (7) reaches the control card (5) by means of the air openings (10) situated above the channel (7).

The fan (8) is disposed behind the card (5) and provides the air from the outer surroundings to enter the channel (7) from the gaps (9) around the knobs (4) by generating forced air circulation and to reach the control card (5) through the air openings (10) arranged over the channel (7) (Figure 7). The air aspirated from the outside by the fan (8) circulates around the electronic card (5) and passes to the rear surface of the card (5) and this air flow cools the card (5).

In another embodiment of the present invention, in the case that an air inlet is provided from the rear of the household appliance (1), the fan (8) cools the card (5) by the air received from behind the panel (2) and the air enters into the channel (7) from the openings (10) arranged around the channel (7) wall to be later discharged to the outside from the gaps (9) disposed between the channel (7) and the portion of the knobs (4) inserted into the channel (7).

The fan (8) can operate connected to the control card (5) or independently from the card (5). The fan (8) is enabled to operate at certain periods, at certain speeds or when the ambient temperature exceeds a certain level.

In an embodiment of the present invention, the panel (2) is shaped like a chamber with the façade facing the interior of the household appliance (1) being open and the other surfaces being closed. In this embodiment, the air aspirated while the fan (8) is operating is discharged from the surroundings by means of the fan (8) after circulating around the card (5).

In another embodiment of the present invention, the household appliance (1) comprises a lid (6) that covers the open rear surface of the panel (2) having a fan (8) situated thereon. A chamber is formed by closing the rear surface of the panel (2) and air circulation is bounded within this chamber. The air aspirated from around the knobs (4) impinges on the front surface of the card (5), disperses over the surface of the card (5) and passes to the rear side of the card (5) from around the card (5) and is discharged outside by means of the fan (8) situated on the lid (6).

In the household appliance (1) of the present invention, since air is aspirated from the outer surroundings by means of the air openings (10) around the knobs (4) there is no need for additional air inlet holes on the household appliance (1) or the panel (2). Consequently, the household appliance (1) and the panel (2) have a more esthetic appearance. Moreover, since numerous knobs (4) are disposed on the panel (2), air is supplied from the outside through numerous places and the air aspirated from the outside flows to various places of the card (5). Therefore, air is dispersed more homogeneously over the card (5) and each region of the card (5) can be cooled more uniformly and effectively.

## Claims

1. A household appliance (1) comprising a **panel (2), a control card (5)** mounted behind the panel (2), at least **one knob (4)** connected to the control card (5), **a fan (8)** disposed behind the control card (5) that cools the control card (5) by supplying air flow, and **a channel (7)** situated on the panel (2) wherein the knob (4) is placed, and **characterized by a gap (9)** between the knob (4) and the channel (7) allowing air to pass, and at least **one opening (10)** situated on the wall of the channel (7)
such that the air enters the channel (7) from the outside and reaches the control card (5) or such that the air enters the channel from the opening (10) and is discharged to the outside through the gap (9).

2. **A household appliance (1) as in Claim 1, characterized by a holding means (3)** disposed in the channel (7), on its end near the control card (5), securing the knob (4) such that a gap (9) is left between the knob (4) and the channel (7).

3. **A household appliance (1) as in Claim 1 or 2, characterized by a lid (6)** that covers the rear surface of the panel (2) forming a cooling chamber in the panel (2) and having a fan (8) mounted thereon.

## Patentansprüche

1. Haushaltsvorrichtung (1), umfassend eine Konsole (2), eine Steuerkarte (5), die hinter der Konsole (2) angeordnet ist, mindestens einen Knopf (4), der mit der Steuerkarte (5) verbunden ist, ein Gebläse (8), das hinter der Steuerkarte (5) angeordnet ist und das die Steuerkarte (5) durch Zuführen eines Luftstroms kühlt, und einen Kanal (7), der an der Konsole (2) angeordnet ist, und in dem der Knopf (4) angeordnet ist, und **gekennzeichnet durch** einen Spalt (9) zwischen dem Knopf (4) und dem Kanal (7), **durch** den Luft treten kann, und wenigstens eine Öffnung (10), die an der Wand des Kanals (7) angeordnet ist, derart, dass die Luft, die in den Kanal (7) eintritt, die Steuerkarte (5) erreicht.

2. Haushaltsvorrichtung (1) nach Anspruch 1, **gekennzeichnet durch** ein Haltemittel (3), das in dem Kanal (7) angeordnet ist, und das an seinem Ende nahe der Steuerkarte (5) den Knopf (4) derart sichert, dass ein Spalt (9) zwischen dem Knopf (4) und dem Kanal (7) bleibt.

3. Haushaltsvorrichtung (1) nach Anspruch 1 oder 2, **gekennzeichnet durch** einen Deckel (6), der die Rückseitenfläche der Konsole (2) abdeckt und in der Konsole (2) eine Kühlkammer bildet, und an dem ein Gebläse (8) angeordnet ist.

## Revendications

1. Un électroménager (1) comprenant un panneau (2), une carte de contrôle (5), monté derrière le panneau (2), au moins un bouton (4) connecté à la carte de contrôle (5), un ventilateur (8) disposé derrière la carte de contrôle (5) qui rafraîchit la carte de contrôle (5) en fournissant un écoulement d'ai, et un canal (7) situé sur le panneau (2) dans lequel le bouton (4) est placé, et **caractérisé par** un espace (9) entre le bouton (4) et le canal (7) permettant à l'air de passer, et au moins une ouverture (10) située sur la paroi du canal (7) de telle sorte que l'air entrant dans le canal (7) atteint à la carte de contrôle (5).

2. Un électroménager (1) selon la Revendication 1, **caractérisé par** un moyen de support (3) disposé dans le canal (7), à son extrémité près de la carte de contrôle (5), fixant le bouton (4) de telle sorte qu'un espace (9) est laissé entre le bouton (4) et le canal (7).

3. Un électroménager (1) selon la Revendication 1 ou 2, **caractérisé par** un couvercle (6) qui couvre la surface arrière du panneau (2) formant une chambre de refroidissement dans le panneau (2) et ayant un ventilateur (8) monté là-dessus.
